# EUROPEAN PATENT APPLICATION

(11) **EP 2 019 082 A1**
(43) Date of publication of application: **28.01.2009**
(21) Application number: 07739162.1
(22) Date of filing: 20.03.2007
(51) Int. Cl.: B82B 3/00, B22F 1/00, C23C 26/00, H01L 29/06

(54) **METHOD FOR FIXING METAL NANOPARTICLE**

(30) Priority: 20.03.2006 JP 2006077059
(71) Applicant: Japan Science and Technology Agency, Kawaguchi-shi, Saitama 332-0012 (JP); Osaka University, Suita-shi Osaka 565-0871 (JP)
(72) Inventor: OJIMA, Kaoru, Kanagawa-ken, (JP); TAKAGI, Akihiko, Osaka (JP); YAMADA, Fumihiko c/o OSAKA UNIVERSITY, 1-1,, Osaka 565-0871 (JP); MATSUMOTO, Takuya c/o OSAKA UNIVERSITY, 1-1,, Osaka 565-0871 (JP); KAWAI, Tomoji c/o OSAKA UNIVERSITY, 1-1,, Osaka 565-0871 (JP)
(74) Representative: Läufer, Martina
(86) International application number: PCT/JP2007/055719
(87) International publication number: WO 2007/108480

(57) **Abstract**

A solution containing polymer-bound metal nanoparticles is deposited onto a substrate, at least the surface of which is insulating, to form a pattern, the substrate is dried, and then the pattern is subjected to plasma exposure.

## Description

### Technical Field

The present invention relates to the method of immobilizing metal nanoparticles.

### Background Art

With the recent development of microprocessing techniques and molecule synthesis techniques, there is an increasing demand for devices with function of a single molecule or a plurality of molecules. DNA is a one-dimensional wire containing information. Synthesis process and commercial supply system for DNA are well established, so that DNA has excellent characteristics and satisfies conditions as a material. With the intention of application to nanoscale molecule devices, gold nanoparticle arrays including DNA have been eagerly studied. In many known studies on the formation of self-organized structures, components of a structure are charged into a solution, and the components are self-organized in the solution or during casting at a stroke (one pot process). However, formation of a molecular device composed of a plurality of markedly heterogeneous substances (materials) requires stepwise and sequential self organization. Sequential self organization occurs in vivo with consummate finesse, and is a commonplace occurrence. However, there is no design guideline for implementing sequential self organization in an artificial system. However, it is known that molecules having certain structures form a distinctive self-assembled structure, which is referred to as a self-organized structure, on a substrate. In addition, orientation and arrangement of molecular structures on a nanoscale can be controlled according to the development conditions on a substrate. Therefore, surface science provides a broad background for the molecular structure on a substrate, and is promising for technical applications to molecular devices.

Making of a device directly based on the above-described nanomolecular structure requires electrodes arranged at intervals narrower than the size of the nanomolecular structure (such minute electrodes are hereinafter generically referred to as "minute electrodes").

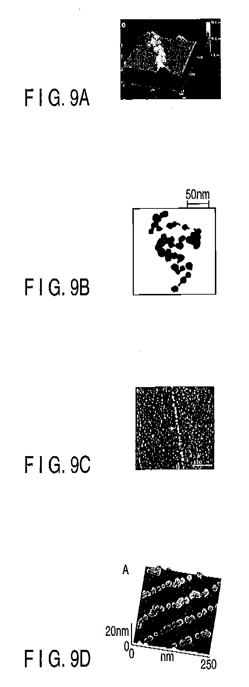

In order to make such minute electrodes, it was attempted to electrochemically deposit a metal on a DNA chain to produce a nanosized wire (see Non-patent Document 1 "Kinneret Keren, Michael Krueger, Rachel Gilad, Gdalyahu Ben-Yoseph, Uri Sivan, and Erez Braun. Science. 279, (2002) 72-75" and Non-patent Document 2 "K. Keren, Y. Soen, G. Ben Yoseph, R, Gilad, E. Braun, U. Sivan, and Y. Talmon. Phy. Rev. lett., 89, (2002) 088103-1-088103-4"). Although a nanoscale wire can be produced by the method, the wire is markedly thick as shown by the AFM images in FIGS. 9A and 9B, wherein rough particles are linked together to form nonuniform aggregates. It is evident that such a wire cannot be used for the formation of elements on a single molecular level.

On the other hand, it has been widely attempted to arrange gold nanoparticles having a uniform particle size along a DNA chain. It is known that, when a mix solution containing gold nanoparticles and DNA is cast on a substrate, the gold nanoparticles adhere exclusively to the DNA as shown in FIG. 9C (see Non-patent Document 3 "Hidenobu Nakao, Hiroshi Shiigi, Yojiro Yamamoto, Shiho Tokonami, Tsutomu Nagaoka, Shigeru Sugiyama and Toshio Ohtani, Nano Lett.; 3 (2003) 1391-1394."). In another example, a base sequence was designed so as to make a DNA structure as shown in FIG. 9D, and the structure was used as a template for arranging gold nanoparticles, by which the gold nanoparticles were arranged at favorable intervals (see Non-patent Document 4 "John D. Le, Yariv Pinto, Nadrian C. Seeman, Karin Musier-Forsyth, T. Andrew Taton, and Richard A. Kiehl. Nano Lett., 4 (2004) 2343-2347").

These known techniques are valued highly as successful examples of self organization based on DNA and gold nanoparticles. However, it is very difficult to utilize these results for forming a device on a molecular scale which provides the function of individual molecules. The reasons for this are as follows.
1) The surface of gold nanoparticles is covered with an organic molecular layer or an antibody, which makes it difficult to make electrical contact with the particles.
2) The structure composed of gold nanoparticles and DNA is water-soluble, which makes it difficult to introduce a hydrophilic molecule between the particles.

As described above, in known techniques, when a plurality of components such as nanoscale particles (hereinafter referred to as "nanoparticles") or molecules are accumulated to make a structure by a bottom up method, these components are commonly synthesized in a solution. Therefore, such structures are often made in a solution by a mixing step. However, when a structure is formed on a solid substrate, as the number of the components increases, it is more practical to deposit solutions sequentially, thereby combining the components and attaching to the substrate. In that case, the structure must not be destroyed by the subsequent operation. When water-soluble gold nanoparticles are dispersed on mica, depositing of a solution of other water-soluble component to be bound to the nanoparticles causes desorption and washing away of the water-soluble nanoparticles into the solution. Therefore, no structure can be formed on the substrate.

### Disclosure of Invention

The present invention is intended to provide a method of immobilizing metal nanoparticles which allows sequential self organization.

The sequential self organization requires the following conditions:
(a) a structure in the current step is formed with the condition that the structure at the previous step is not destroyed but its necessary portions are retained; and
(b) the structure has reactivity enough to allow the introduction of substances in the subsequent step.

Gold nanoparticles are water-soluble because their surfaces are covered with molecules having a hydratable substituent. Accordingly, once the substituent is removed, the nanoparticles lose water solubility. At the same time, they have increased reactivity with thiol molecules. In the present invention, organic molecules covering the particles are removed by oxygen plasma exposure. As a result of this, the gold nanoparticles on the substrate become water-insoluble, and the surfaces of the gold nanoparticles are activated.

The invention according to an aspect of the present invention is method of immobilizing metal nanoparticles including steps of attaching polymer-bound metal nanoparticles onto a substrate at least the surface of which is insulating, drying the substrate, and then subjecting the pattern to plasma exposure.

### Brief Description of Drawings

FIG. 1 shows the flow of immobilizing metal nanoparticles according to a known method and one embodiment of the present invention.
FIG. 2A shows the states of the substrate surface before oxygen plasma exposure.
FIG. 2B shows the states of the substrate surface after oxygen plasma exposure.
FIG. 3A shows the state of desorption of gold nanoparticles from a substrate after rinsing the substrate on which the gold nanoparticles have been immobilized by the method for immobilizing gold nanoparticles according to one embodiment of the present invention.
FIG. 3B shows the state of desorption of gold nanoparticles from a substrate after rinsing the substrate on which the gold nanoparticles have been immobilized by the method for immobilizing gold nanoparticles according to one embodiment of the present invention.
FIG. 3C shows the state of desorption of gold nanoparticles from a substrate after rinsing the substrate on which the gold nanoparticles have been immobilized by the method for immobilizing gold nanoparticles according to one embodiment of the present invention.
FIG. 4A shows the state of desorption of gold nanoparticles from a substrate after rinsing the substrate on which the gold nanoparticles have been immobilized by a known method.
FIG. 4B shows the state of desorption of gold nanoparticles from a substrate after rinsing the substrate on which the gold nanoparticles have been immobilized by a known method.
FIG. 4C shows the state of desorption of gold nanoparticles from a substrate after rinsing the substrate on which the gold nanoparticles have been immobilized by a known method.
FIG. 5 is a graph showing the rate of gold nanoparticles desorbed by rinsing with reference to the number of gold nanoparticles before rinsing designated as 100.
FIG. 6 shows the state of removal of a DNA network and organic substances by oxygen plasma exposure.
FIG. 7 shows the state of DNA obtained after depositing and drying gold nanoparticles bound to one end of SH-dsDNA on a substrate.
FIG. 8A shows the state of extension in one direction of DNA bound to gold nanoparticles, which has been immobilized on a substrate by the immobilization method according to one embodiment of the present invention.
FIG. 8B shows the state of extension in one direction of DNA bound to gold nanoparticles, which has been immobilized on a substrate by the immobilization method according to one embodiment of the present invention.
FIG. 9A illustrates a known art.
FIG. 9B illustrates a known art.
FIG. 9C illustrates a known art.
FIG. 9D illustrates a known art.

### Best Mode for Carrying Out the Invention

The embodiments of the present invention are described with reference to the following drawings.

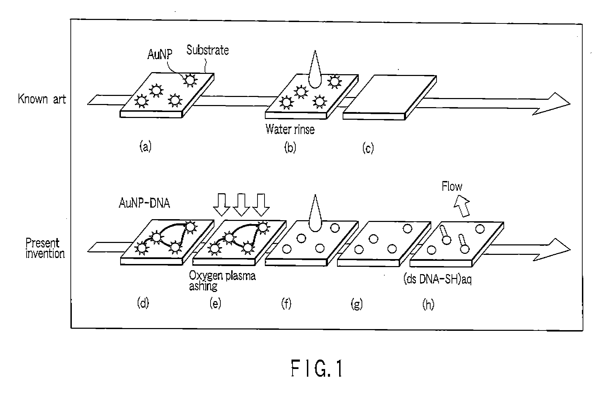

FIG. 1 shows the flow of immobilizing metal nanoparticles (hereinafter referred to as "gold nanoparticles" because "gold" is used as the metal) according to one embodiment of the present invention.

In FIG. 1, FIGS. 1A to 1C show the schematic flow of a known immobilization method, and FIGS. 1D to 1H show the schematic flow of the immobilization method according to the present invention. In the following embodiments, the metal nanoparticles immobilized on the substrate are gold nanoparticles, and a mix solution containing gold nanoparticles and DNA is cast on a substrate as described in Non-patent Document 3 "Hidenobu Nakao, Hiroshi Shiigi, Yojiro Yamamoto, Shiho Tokonami, Tsutomu Nagaoka, Shigeru Sugiyama and Toshio Ohtani, Nano Lett.; 3 (2003) 1391-1394".

The gist of the present invention is that water-soluble gold nanoparticles are immobilized on the surface of a substrate by plasma exposure (hereinafter referred to as "oxygen plasma exposure" because oxygen plasma is used in the embodiment). The plasma treatment removes the organic substance layer from the surfaces of the metal nanoparticles, so that the gold nanoparticles immobilized on the surfaces can be used as anchors to be bound to molecules having a thiol group.

In a known art, firstly, water-soluble gold nanoparticles (AuNP) are immobilized on an insulating substrate (FIG, 1A). Secondly, the substrate is rinsed (washed) with water to remove dust and other contaminants from the substrate (FIG. 1B). The rinsing removes even necessary gold nanoparticles from the substrate because the particles are water-soluble (FIG. 1C).

On the other hand, in the embodiment of the present invention, a mix solution containing gold nanoparticles and DNA (AuNP-DNA) is immobilized on a substrate (FIG. 1D), and then ashed by oxygen plasma exposure (FIG. 1E). As a result of this, the DNA molecules are decomposed, and only the gold nanoparticles remain on the substrate. In this case, the gold nanoparticles remaining on the substrate are not water-soluble, so that they remain on the substrate after rinsing (FIGS. 1F and 1G). The gold nanoparticles remaining on the substrate have high surface activity, and thus are highly reactive with, for example, thiol molecules. As a result of this, gold nanoparticles can be combined with water-soluble terminal double-stranded DNA((dsDNA-SH)aq) (FIG. 1H).

The practical making procedure and an electrode made by the method are described below in detail. The apparatus according to the embodiment is the same as a known apparatus composed of a dispensing device for depositing DNA on a substrate, a dryer, and a washing device, so that illustration and explanation thereof are omitted.

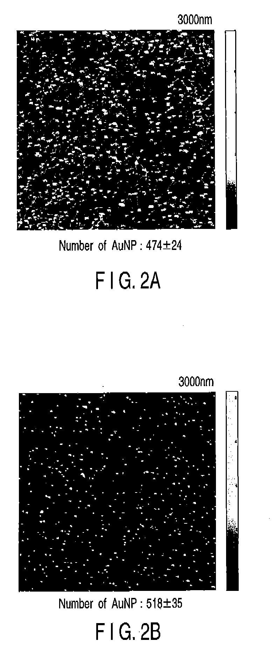

Firstly, water-soluble gold nanoparticles having a particle size of 5 nm is dissolved in a solution at a concentration of 5 × 10¹³/ml. Subsequently, 25 U (1250 ng/1) of DNA and 3 × 10¹⁴/ml of the gold nanoparticles are mixed, and centrifuged. Then, the gold nanoparticles (and DNA) are cast over the surface of an insulating substrate, and blow-dried after a lapse of 1 to 3 minutes. As a result of this, a network structure is formed (see FIG. 2A). As shown in FIG. 2A, a network structure of DNA connecting water-soluble gold nanoparticles is formed. When the substrate was subjected to oxygen plasma exposure, the DNA network structure disappeared (see FIG. 2B). In this case, the numbers of AuNP before and after oxygen plasma exposure (FIGS. 2A and FIG. 2B, respectively) are 474 ± 2 and 518 ± 35 per 9 µm² (3 µm × 3 µm), respectively. The exposure to oxygen plasma was conducted for 1 minute under a pressure of 1 Torr and with a power of 40W. The power of the plasma was 40W, but is preferably 50W or less in the embodiment, though the power must be higher than specified power. If the power is too low, plasma discharge will not occur.
Also the period of the plasma exposure was 1 minute, but is preferably from 30 seconds to 2 minutes. In such a condition, only the surface can be reformed without moving the gold nanoparticles. The oxygen plasma treatment is one of the dry etching methods widely used in semiconductor processes. An organic substance is removed by decomposing and evaporating the organic substance into CO₂ and H₂O by active oxygen induced by oxygen plasma (oxygen radical). Since oxygen plasma will not emit harmful waste water or the like, it imposes less environment load than a wet process using a solution.

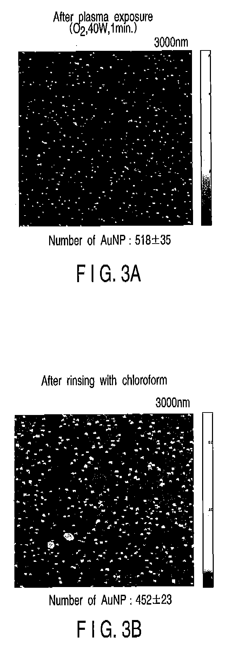

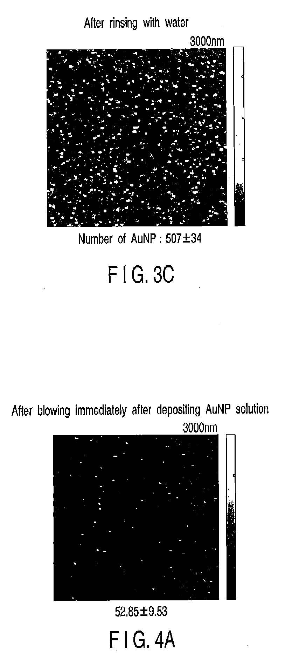

Secondly, the substrate was rinsed after oxygen plasma exposure. The rinsing was conducted with chloroform as a nonpolar solvent, and water as a polar solvent. The number of AuNP remaining on the substrate was 518 ± 35 per 9 µm² after the oxygen plasma exposure (see FIG. 3A), 452 ± 23 after rinsing with chloroform (see FIG. 3B), and 507 ± 34 after rinsing with water (see FIG. 3C). Accordingly, it was confirmed that the gold nanoparticles after oxygen plasma exposure are scarcely desorbed by rinsing with a polar or nonpolar solvent.

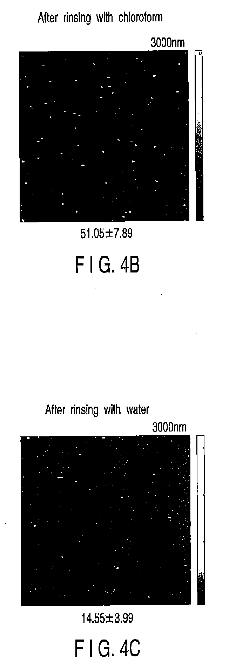

Comparative examples involving no oxygen plasma are described with reference to FIGS. 4A to 4C. When the solution containing gold nanoparticles was blow-dried immediately after being deposited, the number of AuNP remaining on the substrate was 52.85 ± 9.35 per 9 µm², (see FIG. 4A), 51.05 ± 7.89 after rinsing with chloroform (see FIG. 4B), and 14.55 ± 3.99 after rinsing with water (see FIG. 4C). Accordingly, when oxygen plasma exposure is not conducted, the gold nanoparticles were scarcely desorbed by rinsing with chloroform as a nonpolar solvent, but a considerable number of gold nanoparticles were desorbed by rinsing with water as a polar solvent.

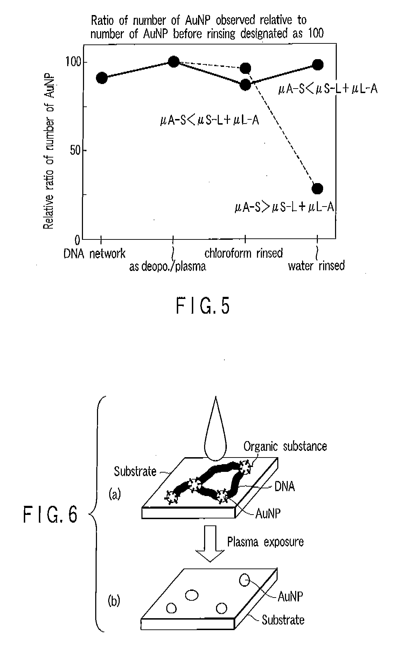

FIG. 5 is a graph showing the rate of gold nanoparticles desorbed by rinsing with reference to the number of gold nanoparticles before rinsing designated as 100. As shown in FIG. 5, the rate of gold nanoparticles desorbed by rinsing with chloroform as a nonpolar solvent was not differed between those exposed or not exposed to oxygen plasma, but the desorption rate differed by about 4 times when rinsed with water as a polar solvent. As shown in FIG. 6, when a solution containing gold nanoparticles is deposited, a DNA network structure is formed (see FIG. 6A). At this time, the gold nanoparticles are surrounded by an organic substance. When the substrate in this state is subjected to oxygen plasma exposure, the DNA and organic substance are decomposed to expose the active surface of the gold nanoparticles at the surface of the substrate (see FIG. 6B).

In the below-described embodiment, the gold nanoparticles are bound to one end of SH-dsDNA.

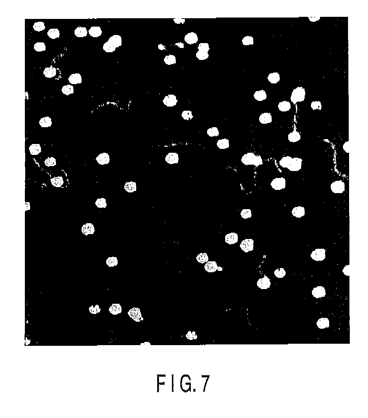

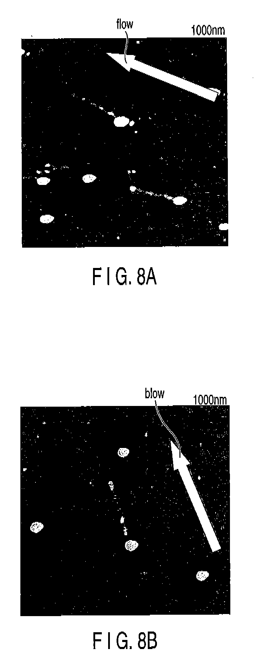

When the gold nanoparticles bound to one end of SH-dsDNA are deposited on a substrate and dried, as shown in FIG. 7, the direction and shape are not orientational, and many pieces of the SH-dsDNA are not bound to the gold nanoparticles. On the other hand, as shown in FIGS. 8A and 8B, when water was caused to flow in one direction (the direction indicated by an arrow, FIG. 8A), or air is blown in one direction onto the substrate (FIG. 8B), it was observed that the DNA extended in one direction with the one end of which bound to (or immobilized on) the gold nanoparticles. Most of the DNA not bound to the gold nanoparticles was washed away and not observed. These facts indicate that the gold nanoparticles stably remained on the substrate even in the solution, the gold nanoparticles were strongly bound to thiol, and the DNA was immobilized on the substrate through the gold nanoparticles.

As described above, in the embodiment of the present invention, a composite of gold nanoparticles adsorbed to a DNA network structure formed on mica is subjected to oxygen plasma exposure, thereby destroying the DNA to leave the gold nanoparticles. The gold nanoparticles can be immobilized on mica, and will not desorbed by water. In addition, when a solution of DNA one end of which has been thiol-modified is caused to flow in one direction and dried, a structure composed of DNA extending in the flow direction from the immobilized nanoparticles and being immobilized by the gold-thiol bond is formed. The method is effective for the sequential formation of a nanostructure.

As described in the above embodiment, in the present invention, DNA and organic substances are ashed by oxygen plasma to be removed, thereby immobilizing gold nanoparticles on a substrate. Therefore, the substrate is preferably not to be degraded by oxygen plasma exposure. The substrate may be, for example, an Si substrate whose surface has been oxidized to form an SiO₂ layer. The substrate may be any one such as mica, sapphire, MgO, glass, or titanium oxide as long as the substrate surface is an oxide or can be coated with an oxide. It is a matter of course that the sample preferably contains no material such as resist which can be etched by oxygen plasma exposure.

The oxygen plasma exposure apparatus may be a common one, and is preferably clean and will not cause surface contamination by plasma exposure. In addition, the plasma exposure is preferably conducted with a minimum power and period sufficient for removing the organic substance.

The present invention is not limited to the above embodiments, and various modification may be made in the implementation phase without departing from the scope of the invention.

In the above embodiments, gold nanoparticles are used as the metal particles, but the particles are not limited to gold, and may be, for example, silver, platinum, cobalt, iron, or Cd-Se. In addition, the plasma emitted to the sample is most preferably oxygen to decompose the DNA and organic substance, but the plasma emitted for decomposing the DNA and other organic substance may be other than oxygen plasma as long as it decomposes the organic substance.

In the above embodiments, a solution containing metal nanoparticles was deposited on and attached to a substrate. The invention is not limited to the embodiment, and the nanoparticles may be attached by immersion or LB (Langmuir-Blodgett) method.

The embodiments described above include inventions of various stages, and the various inventions can be extracted by a proper combination of a plurality of disclosed components.

For example, if the problem described in Problems To Be Solved by Invention can be solved and the advantages described in Advantageous Effect of the Invention are achieved even when several components are deleted from all the components of the embodiments, the structure from which the several components have been deleted can be extracted as one invention.

### Industrial Applicability

The present invention provides a method of immobilizing metal nanoparticles which allows sequential self organization. In addition, the present invention is applicable to the production of substrates for biochips and nanosensors.

## Claims

1. A method of immobilizing metal nanoparticles, **characterized by** comprising:
attaching polymer-bound metal nanoparticles onto a substrate at least the surface of which is insulating;
drying the substrate; and
subjecting the pattern to plasma exposure.

2. The method of immobilizing metal nanoparticles according to claim 1, **characterized in that** the polymer comprises a water-soluble organic compound.

3. The method of immobilizing metal nanoparticles according to claim 1 or 2, **characterized in that** the polymer comprises a DNA.

4. The method of immobilizing metal nanoparticles according to any one of claims 1 to 3, **characterized in that** the plasma is oxygen plasma.

5. The method of immobilizing metal nanoparticles according to any one of claims 1 to 4, **characterized in that** the metal nanoparticles are gold nanoparticles.

6. The method of immobilizing metal nanoparticles according to any one of claims 1 to 5, **characterized in that** after the plasma exposure, the substrate surface is washed, one end of the DNA chain is bound to the metal nanoparticles, and the DNA chain is arranged in one direction.

7. The method of immobilizing metal nanoparticles according to claim 6, **characterized in that** the DNA chain is a thiolated DNA.

8. The method of immobilizing metal nanoparticles according to any one of claims 1 to 7, **characterized in that** the attaching step includes depositing of a solution containing metal nanoparticles, immersing the substrate into the solution, or a LB method.

9. The method of immobilizing metal nanoparticles according to any one of claims 1 to 8, **characterized in that** the power of the plasma exposure is 50W or less.

10. The method of immobilizing metal nanoparticles according to any one of claims 1 to 9, **characterized in that** the period of the plasma exposure is from 30 seconds to 2 minutes.
